# FASCICULE DE BREVET EUROPEEN

(11) **EP 4 361 656 B1**
(45) Date de publication et mention de la délivrance du brevet: **25.03.2026**
(21) Numéro de dépôt: 23203548.5
(22) Date de dépôt: 13.10.2023
(51) Int. Cl.: G05F 3/30, G01R 31/3187, G01R 31/40

(54) **CIRCUIT ELECTRONIQUE COMPRENANT UN CIRCUIT DE RÉFÉRENCE DE TENSION ET UN CIRCUIT DE TEST DE DÉMARRAGE**
ELEKTRONISCHE SCHALTUNG MIT SPANNUNGSREFERENZSCHALTUNG UND STARTTESTSCHALTUNG
ELECTRONIC CIRCUIT COMPRISING A VOLTAGE REFERENCE CIRCUIT AND A START-UP TEST CIRCUIT

(30) Priorité: 24.10.2022 FR 2211019
(43) Date de publication de la demande: 01.05.2024
(73) Titulaire: STMICROELECTRONICS (GRENOBLE 2) SAS, 38000 Grenoble (FR); STMicroelectronics (ALPS) SAS, 38000 Grenoble (FR)
(72) Inventeur: GOULIER, Julien, 38000 GRENOBLE (FR); GOUX, Nicolas, 38400 SAINT-MARTIN-D'HERES (FR); JOISSON, Marc, 38320 BRIE ET ANGONNES (FR)
(74) Mandataire: Cabinet Beaumont

(56) Documents cités:
- JP-A- 2005 189 927
- JP-A- 2015 207 201
- US-A1- 2011 001 555
- US-A1- 2018 253 118

## Description

La présente demande de brevet revendique la priorité de la demande de brevet français FR22/11019.

### Domaine technique

La présente description concerne de façon générale les circuits de référence de tension, en particulier un circuit électronique comprenant un circuit de référence de tension et un circuit de test de démarrage du circuit de référence de tension.

### Technique antérieure

Un circuit de référence de tension est un circuit électronique fournissant une référence de tension, c'est-à-dire une tension constante qui est sensiblement indépendante de la température et de la tension d'alimentation. Cette référence de tension est utilisée par d'autres éléments du circuit électronique. Le circuit de référence de tension est alimenté par une source d'une tension d'alimentation externe au circuit électronique.

Pour certaines applications, par exemple pour des applications dans le domaine bancaire, il est nécessaire de vérifier que le circuit de référence de tension a démarré de façon correcte lorsque la tension d'alimentation augmente de 0 V à une valeur nominale. Dans ce but, le circuit électronique comprend un circuit de test de démarrage qui peut reproduire la structure globale du circuit de référence de tension. Le circuit de référence de tension fournit des signaux de test représentatifs de l'état de noeuds internes qui sont comparés aux mêmes signaux fournis par le circuit de test de démarrage. Si le démarrage du circuit de référence de tension se passe normalement, il est supposé que les signaux de test fournis par le circuit de référence de tension et le circuit de test de démarrage doivent être identiques. Lorsque les signaux de test fournis par le circuit de référence de tension et le circuit de test de démarrage sont différents, cela signifie que le démarrage du circuit de référence de tension ne s'est pas déroulé de façon correcte.

Un inconvénient d'un tel circuit de test de démarrage est qu'il a une structure complexe puisqu'il reproduit globalement la structure du circuit de référence de tension, et qu'il occupe une surface importante de la surface totale du circuit électronique, notamment lorsque ce circuit est réalisé de façon intégré. Le document US 2011/001555 décrit un circuit de test pour un circuit de référence de tension.

### Résumé de l'invention

L'invention est telle que définie dans la revendication 1.

Un mode de réalisation pallie tout ou partie des inconvénients des circuits électroniques connus comprenant un circuit de référence de tension et un circuit de test de démarrage du circuit de référence de tension.

Selon un objet d'un mode de réalisation, la surface occupée par le circuit de test de démarrage est réduite par rapport à la surface occupée par le circuit de référence de tension lorsque ces circuits sont réalisés de façon intégrée.

Selon un objet d'un mode de réalisation, la structure du circuit de test de démarrage est simple.

Un mode de réalisation prévoit un circuit électronique comprenant un circuit de référence de tension et un circuit de test de démarrage du circuit de référence de tension, le circuit de référence de tension comprenant au moins un premier empilement d'un premier transistor, comprenant une première borne de commande recevant un premier signal de commande, et d'un deuxième transistor, comprenant une deuxième borne de commande recevant un deuxième signal de commande, et le circuit de test de démarrage comprenant au moins un premier circuit de test élémentaire comprenant un deuxième empilement d'un troisième transistor et d'un quatrième transistor, le troisième transistor étant du même type que le premier transistor et comprenant une troisième borne de commande recevant le premier signal de commande, le quatrième transistor étant du même type que le deuxième transistor et comprenant une quatrième borne de commande recevant le deuxième signal de commande, le premier circuit de test élémentaire étant configuré pour fournir un premier signal binaire.

Selon un mode de réalisation, le circuit de référence de tension est destiné à être connecté à une source d'une tension d'alimentation et à une source d'un potentiel de référence. Le premier transistor et le deuxième transistor sont reliés en série entre la source de la tension d'alimentation et la source du potentiel de référence, et le troisième transistor et le deuxième transistor sont reliés en série entre la source de la tension d'alimentation et la source du potentiel de référence.

Selon un mode de réalisation, les premier, deuxième, troisième et quatrième transistors sont des transistors MOS.

Selon un mode de réalisation, le premier transistor et le deuxième transistor sont du même type, et le premier circuit de test élémentaire comprend, en outre, un cinquième transistor en série avec un sixième transistor, le cinquième transistor comprenant une cinquième borne de commande recevant le premier signal de commande et le sixième transistor comprenant une sixième borne de commande recevant un signal à un noeud intermédiaire du deuxième empilement, le premier signal binaire correspondant à la tension au noeud milieu entre le cinquième transistor et le sixième transistor.

Selon un mode de réalisation, le circuit de référence de tension comprend au moins un troisième empilement d'un septième transistor, comprenant une septième borne de commande recevant un troisième signal de commande, et d'un huitième transistor, comprenant une huitième borne de commande recevant un quatrième signal de commande, et le circuit de test de démarrage comprend au moins un deuxième circuit de test élémentaire comprenant un quatrième empilement d'un neuvième transistor et d'un dixième transistor, le neuvième transistor étant du même type que le septième transistor et comprenant une neuvième borne de commande recevant le troisième signal de commande, le dixième transistor étant du même type que le huitième transistor et comprenant une dixième borne de commande recevant le quatrième signal de commande, le deuxième circuit de test élémentaire étant configuré pour fournir un deuxième signal binaire.

Selon un mode de réalisation, le troisième signal de commande est identique au premier signal de commande.

Selon un mode de réalisation, le septième transistor et le huitième transistor sont reliés en série entre la source de la tension d'alimentation et la source du potentiel de référence, et le neuvième transistor et le dixième transistor sont reliés en série entre la source de la tension d'alimentation et la source du potentiel de référence.

Selon un mode de réalisation, le septième transistor et le huitième transistor sont de types différents, et le deuxième signal binaire correspond à la tension au noeud milieu entre le neuvième transistor et le dixième transistor.

Selon un mode de réalisation, les septième, huitième, neuvième et dixième transistors sont des transistors MOS.

Selon un mode de réalisation, le circuit électronique comprend un circuit PTAT, un premier étage d'amplification, et un deuxième étage d'amplification, le premier étage d'amplification comprenant un onzième transistor et un douzième transistor, le deuxième signal de commande étant la tension à une borne de puissance du onzième transistor, et le quatrième signal de commande étant la tension à une borne de puissance du douzième transistor.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un schéma électrique d'un circuit de référence de tension et d'un circuit de test de démarrage ;
la figure 2 représente un mode de réalisation d'un circuit de référence de tension ;
la figure 3 est un schéma par blocs d'un mode de réalisation d'un circuit de test de démarrage d'un circuit de référence de tension ;
la figure 4 représente un circuit comprenant le circuit de référence de tension de la figure 2 et un mode de réalisation d'un circuit de test de démarrage ;
la figure 5 représente un mode de réalisation d'un circuit de test élémentaire du circuit de test de démarrage de la figure 4 ;
la figure 6 représente un mode de réalisation d'un autre circuit de test élémentaire du circuit de test de démarrage de la figure 4 ;
la figure 7 représente des chronogrammes de tensions du circuit de la figure 2 ; et
la figure 8 représente un autre mode de réalisation d'un circuit de référence de tension.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

De plus, on appelle "signal binaire" un signal qui alterne entre un premier état constant, par exemple un état bas, noté "0", et un deuxième état constant, par exemple un état haut, noté "1". Les états haut et bas de signaux binaires différents d'un même circuit électronique peuvent être différents. En pratique, les signaux binaires peuvent correspondre à des tensions ou à des courants qui peuvent ne pas être parfaitement constants à l'état haut ou bas. Dans la suite de la description, on appelle "bornes de puissance" d'un transistor MOS la source et le drain du transistor MOS et "bornes de puissance" d'un transistor bipolaire le collecteur ou l'émetteur du transistor bipolaire. De plus, on appelle "borne de commande" d'un transistor MOS la grille du transistor MOS et "borne de commande" d'un transistor bipolaire la base du transistor bipolaire. En outre, sauf indication contraire, lorsque l'on parle d'une tension en un noeud, on considère la différence entre le potentiel audit noeud et un potentiel de référence, par exemple la masse, pris égal à 0 V.

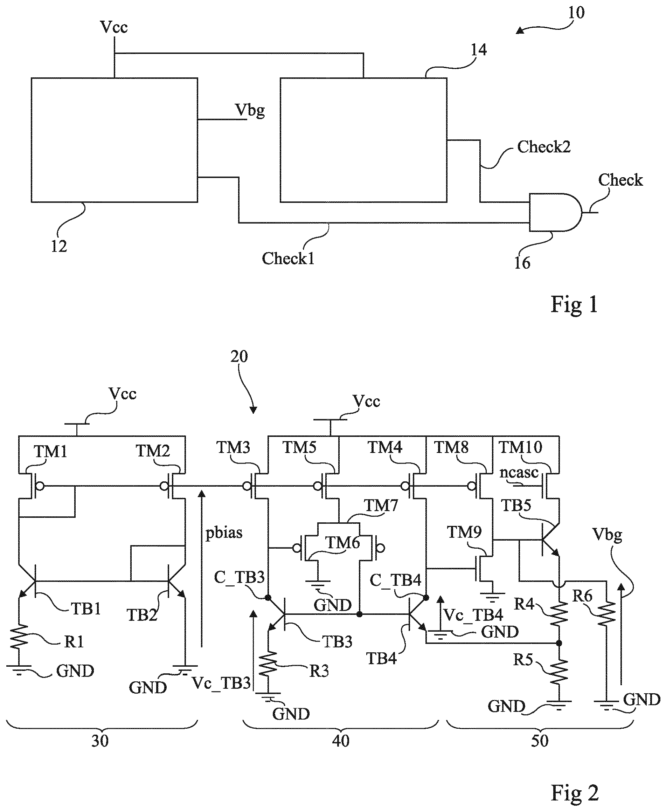

La figure 1 représente, de façon partielle et schématique, un circuit électronique 10 comprenant un circuit de référence de tension 12 alimenté par une tension d'alimentation Vcc et fournissant une référence de tension Vbg, c'est-à-dire une tension qui est sensiblement constante et indépendante de la température et de la tension d'alimentation.

Pour certaines applications, par exemple pour des applications dans le domaine bancaire, il est nécessaire de vérifier que le circuit de référence de tension 12 a démarré de façon correcte lorsque la tension d'alimentation Vcc augmente de 0 V à une valeur nominale. Dans ce but, le circuit électronique 10 comprend un circuit de test de démarrage 14. Selon un exemple, le circuit de test de démarrage 14 peut reproduire en partie ou en totalité la structure du circuit de référence de tension 12. Le circuit de référence de tension 12 fournit des signaux binaires Check1, représentatifs de l'état de noeuds internes du circuit de référence de tension 12, et le circuit de test de démarrage 14 fournit les mêmes signaux binaires Check2. Un circuit logique 16, par exemple une porte logique de type ET, reçoit en entrée les signaux binaires Check1 et Check2 et fournit un signal binaire Check. Si le démarrage du circuit de référence de tension 12 se passe normalement, il est supposé que les signaux binaires Check1 et les signaux binaires Check2 doivent être identiques. Le signal binaire Check est par exemple alors à l'état logique "1". Lorsque le signal binaire Check est à l'état logique **"0",** cela signifie que le démarrage du circuit de référence de tension 12 ne s'est pas déroulé de façon correcte.

Un inconvénient du circuit de test 14 est qu'il a une structure complexe puisqu'il reproduit au moins partiellement la structure du circuit de référence de tension 12, et qu'il occupe une surface importante de la surface totale du circuit 10 lorsque le circuit 10 est réalisé de façon intégré.

La figure 2 est un schéma électrique d'un mode de réalisation d'un circuit de référence de tension 20.

Le circuit de référence de tension 20 comprend un circuit PTAT 30 de fourniture d'une tension de polarisation pbias, un premier étage d'amplification 40, et un deuxième étage d'amplification 50.

Le circuit PTAT 30 comprend :
- un transistor bipolaire TB1, par exemple de type NPN, dont l'émetteur est relié, de préférence connecté, à une borne d'une résistance R1, l'autre borne de la résistance R1 étant reliée, de préférence connectée, à une source d'un potentiel de référence bas GND, par exemple la masse ;
- un transistor bipolaire TB2, par exemple de type NPN, dont l'émetteur est relié, de préférence connecté, à la source du potentiel de référence bas GND, et dont la base est reliée, de préférence connectée, au collecteur du transistor bipolaire TB2 et à la base du transistor bipolaire TB1 ;
- un transistor TM1 à effet de champ à grille isolée, également appelé transistor MOS, par exemple à canal P, dont la source est reliée, de préférence connectée, à une source de la tension d'alimentation Vcc, dont le drain est relié, de préférence connecté, au collecteur du transistor bipolaire TB1, et dont la grille est reliée, de préférence connectée, au drain ; et
- un transistor MOS TM2, par exemple à canal P, dont la source est reliée, de préférence connectée, à la source de la tension d'alimentation Vcc, dont le drain est relié, de préférence connecté, au collecteur du transistor bipolaire TB2, et dont la grille est reliée à la grille du transistor MOS TM1. On appelle pbias la tension à la grille du transistor MOS TM2.

Le circuit de référence de tension 20 comprend en outre un circuit de démarrage du circuit PTAT 30 qui n'est pas représenté en figure 2.

Le premier étage d'amplification 40 comprend :
- un transistor bipolaire TB3, par exemple de type NPN, dont l'émetteur est relié, de préférence connecté, à une borne d'une résistance R3, l'autre borne de la résistance R3 étant reliée, de préférence connectée, à la source du potentiel de référence bas GND ;
- un transistor bipolaire TB4, par exemple de type NPN, dont la base est reliée, de préférence connectée, à la base du transistor bipolaire TB3 ;
- un transistor MOS TM3, par exemple à canal P, dont la source est reliée, de préférence connectée, à la source de la tension d'alimentation Vcc, dont le drain est relié, de préférence connecté, au collecteur C_TB3 du transistor bipolaire TB3, et dont la grille est reliée, de préférence connectée, à la grille du transistor MOS TM2 ;
- un transistor MOS TM4, par exemple à canal P, dont la source est reliée, de préférence connectée, à la source de la tension d'alimentation Vcc, dont le drain est relié, de préférence connecté, au collecteur C_TB4 du transistor bipolaire TB4, et dont la grille est reliée, de préférence connectée, à la grille du transistor MOS TM2 ;
- un transistor MOS TM5, par exemple à canal P, dont la source est reliée, de préférence connectée, à la source de la tension d'alimentation Vcc, et dont la grille est reliée, de préférence connectée, à la grille du transistor MOS TM2 ;
- un transistor MOS TM6, par exemple à canal P, dont la source est reliée, de préférence connectée, au drain du transistor TM5, dont la grille est reliée, de préférence connectée, au collecteur C_TB3 du transistor bipolaire TB3, et dont le drain est relié, de préférence connecté, à la source du potentiel de référence bas GND ; et
- un transistor MOS TM7, par exemple à canal P, dont la source est reliée, de préférence connectée, au drain du transistor MOS TM5, dont la grille est reliée, de préférence connectée, à la base du transistor bipolaire TB4, et dont le drain est relié, de préférence connecté, à la base du transistor bipolaire TB4.

Le deuxième étage d'amplification 50 comprend :
- un transistor MOS TM8, par exemple à canal P, dont la source est reliée, de préférence connectée, à la source de la tension d'alimentation Vcc, et dont la grille est reliée, de préférence connectée, à la grille du transistor TM2 ;
- un transistor MOS TM9, par exemple à canal N, dont la source est reliée, de préférence connectée, à la source du potentiel de référence bas GND, dont le drain est relié, de préférence connecté, au drain du transistor MOS TM8, et dont la grille est reliée, de préférence connectée, au collecteur C_TB4 du transistor TB4 ;
- un transistor bipolaire TB5, par exemple de type NPN, dont la base est reliée, de préférence connectée, au drain du transistor MOS TM9 ;
- un transistor MOS TM10, par exemple à canal N, dont le drain est relié, de préférence connecté, à la source de la tension d'alimentation Vcc, dont la source est reliée, de préférence connectée, au collecteur du transistor bipolaire TB5, et dont la grille reçoit une tension ncasc ; et
- une résistance R4 dont une borne est reliée, de préférence connectée, à l'émetteur du transistor bipolaire TB5, et dont l'autre borne est reliée, de préférence connectée, à l'émetteur du transistor TB4, une résistance R5 dont une borne est reliée, de préférence connectée, à l'émetteur du transistor bipolaire TB4, et dont l'autre borne est reliée, de préférence connectée, à la source du potentiel de référence bas GND, et une résistance R6 dont une borne est reliée, de préférence connectée, à la base du transistor bipolaire TB5 et dont l'autre borne est reliée, de préférence connectée, à la source du potentiel de référence bas GND.

Dans la suite de la description, on appelle Vc_TB3 la tension au collecteur C_TB3 du transistor bipolaire TB3 et Vc_TB4 la tension au collecteur C_TB4 du transistor bipolaire TB4. La référence de tension Vbg fournie par le circuit 20 correspond à la tension aux bornes de la résistance R6. A titre de variante, le transistor MOS TM10, qui permet d'éviter que la tension au collecteur du transistor bipolaire TB5 ne s'élève trop, peut ne pas être présent, le collecteur du transistor bipolaire TB5 pouvant être alors connecté à la source de la tension d'alimentation Vcc.

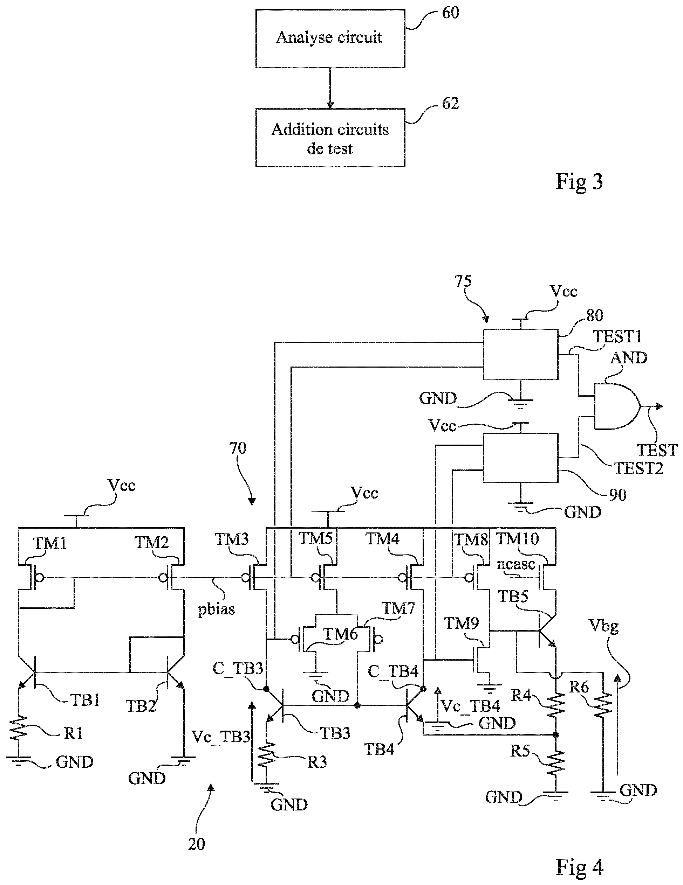

La figure 3 est un schéma par blocs d'un mode de réalisation d'un procédé de conception d'un circuit de test de démarrage pour un circuit de référence de tension.

Selon un mode de réalisation, le procédé comprend une étape 60 d'analyse du circuit de référence de tension et une étape de détermination 62 d'un circuit de test de démarrage adapté au circuit de référence de tension.

A l'étape 60, une analyse du circuit de référence de tension est réalisée pour déterminer les empilements de transistors MOS et/ou bipolaires du circuit de référence de tension les plus critiques lors du démarrage du circuit de référence de tension. Un empilement de transistors comprend au moins deux transistors en série entre la source de la tension d'alimentation Vcc et la source du potentiel de référence bas GND. Un empilement critique est un empilement de transistors du circuit de référence de tension comprenant au moins deux transistors en série entre la source de la tension d'alimentation Vcc et la source du potentiel de référence bas GND et pour lequel la tension à un noeud intermédiaire de l'empilement présente la probabilité la plus élevée de ne pas atteindre une valeur cible si la tension d'alimentation Vcc n'est pas suffisamment élevée.

Selon un mode de réalisation, l'empilement critique correspond à un montage suiveur. Selon un autre mode de réalisation, l'empilement critique correspond à une branche contenant le transistor d'une paire différentielle.

Pour le circuit de référence de tension 20 représenté en figure 2, un premier empilement critique correspond à l'empilement formé par les transistors MOS TM5 et TM6 qui forme un montage suiveur. Un deuxième empilement critique correspond à l'empilement formé par les transistors MOS TM8 et TM9 qui forme un montage amplificateur.

A l'étape 62, il est déterminé un circuit de test de démarrage pour le circuit de référence de tension. Le circuit de test de démarrage comprend un circuit de test élémentaire pour chaque empilement critique déterminé à l'étape 60. Chaque circuit de test élémentaire reçoit en entrée les tensions reçues par l'empilement critique testé et fournit un signal binaire à un premier état logique, par exemple l'état logique "1", lorsque la tension au noeud intermédiaire de l'empilement critique testé est suffisamment élevée et à un deuxième état logique, par exemple l'état logique "0", lorsque la tension au noeud intermédiaire de l'empilement critique testé n'est pas suffisamment élevée. Selon la structure du circuit de référence de tension, le circuit de test de démarrage peut comprendre un seul circuit de test élémentaire, deux circuits de test élémentaire, ou plus de deux circuits de test élémentaire. De préférence, le circuit de test de démarrage comprend au moins deux circuits de test élémentaire.

Selon un mode de réalisation, chaque circuit de test élémentaire reproduit au minimum l'empilement de transistors (MOS ou bipolaire) testé. Les transistors de l'empilement reproduit du circuit de test élémentaire reçoivent les mêmes signaux que les transistors de l'empilement testé du circuit de référence de tension. Il peut en outre être prévu en série avec les transistors de l'empilement reproduit du circuit de test élémentaire un composant électronique supplémentaire ou des composants électroniques supplémentaires, par exemple une résistance, une diode, un transistor MOS monté en diode, etc. Le composant électronique supplémentaire ou les composants électroniques supplémentaires sont de préférence situés entre la source du potentiel de référence bas GND et l'empilement reproduit et/ou entre la source de la tension d'alimentation Vcc et l'empilement reproduit pour ajuster les tensions entre les bornes de puissance des transistors de l'empilement reproduit.

Selon un mode de réalisation, dans le cas où l'empilement critique testé comprend deux transistors MOS de type opposé, par exemple un transistors MOS à canal P et un transistor MOS à canal N, le circuit de test élémentaire comprend également un empilement d'un transistor MOS à canal P et d'un transistor MOS à canal N, et le signal de test élémentaire correspond à la tension au noeud intermédiaire entre le transistors MOS à canal P et le transistor MOS à canal N. Selon un mode de réalisation, dans le cas où l'empilement critique testé comprend deux transistors MOS du même type, par exemple deux transistors MOS à canal P ou deux transistors MOS à canal N, le circuit de test élémentaire comprend également un premier empilement de deux transistors MOS de ce type et comprend, en outre, un deuxième empilement d'un transistor MOS à canal P et d'un transistor MOS à canal N. La grille de l'un du transistor MOS à canal P ou du transistor MOS à canal N du deuxième empilement est reliée, de préférence connectée, au noeud intermédiaire entre les deux transistors du même type du premier empilement, et le signal de test élémentaire correspond à la tension au noeud intermédiaire entre le transistors MOS à canal P et le transistor MOS à canal N du deuxième empilement.

La figure 4 représente un circuit de référence de tension équipé 70 comprenant le circuit de référence de tension 20 représenté en figure 2 et un circuit de test de démarrage 75. Le circuit de test de démarrage 75 comprend deux circuits de test élémentaire 80 et 90. Chaque circuit de test élémentaire 80 et 90 est relié à la source de la tension d'alimentation Vcc et à la source du potentiel de référence bas GND. Le premier circuit de test élémentaire 80 reçoit en entrée la tension Vc_TB3 au collecteur C_TB3 du transistor bipolaire TB3 et la tension pbias à la grille du transistor TM2 et fournit un signal binaire de test élémentaire TEST1. Le deuxième circuit de test élémentaire 90 reçoit en entrée la tension Vc_TB4 au collecteur C_TB4 du transistor bipolaire TB4 et la tension pbias à la grille du transistor TM2 et fournit un signal binaire de test élémentaire TEST2. Selon un mode de réalisation, le circuit de test 75 comprend en outre un porte logique AND de type ET recevant les signaux de test élémentaire TEST1 et TEST2 et fournissant un signal binaire de test de démarrage TEST. Le signal de test de démarrage TEST est à l'état logique "1" lorsque les deux signaux de test élémentaire TEST1 et TEST2 sont chacun à l'état logique "1", et est à l'état logique "0" lorsqu'au moins l'un des signaux de test élémentaire TEST1 et TEST2 est à l'état logique "0".

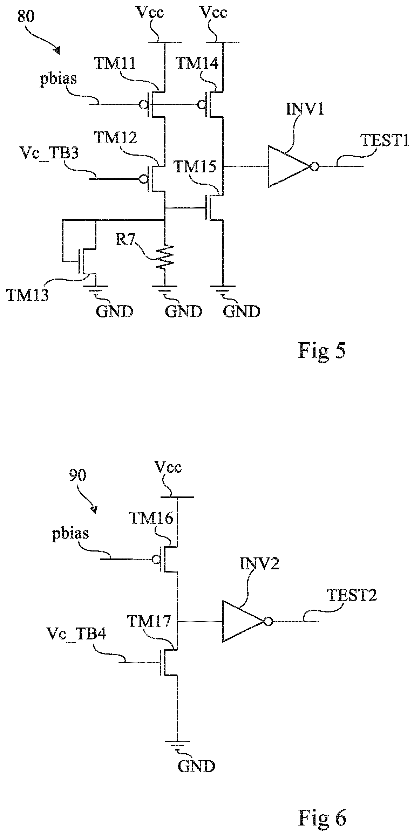

La figure 5 est un schéma électrique d'un mode de réalisation du premier circuit de test élémentaire 80.

Le circuit de test élémentaire 80 comprend :
- un transistor MOS TM11 par exemple à canal P, dont la source est reliée, de préférence connectée, à la source de la tension d'alimentation Vcc, et dont la grille reçoit la tension pbias ;
- un transistor MOS TM12 par exemple à canal P, dont la source est reliée, de préférence connectée, au drain du transistor MOS TM11, et dont la grille reçoit la tension Vc_TB3 au collecteur du transistor bipolaire TB3 ;
- une résistance R7 dont une borne est reliée, de préférence connectée, au drain du transistor MOS TM12, et dont l'autre borne est reliée, de préférence connectée, à la source du potentiel de référence bas GND ;
- un transistor MOS TM13, par exemple à canal N, dont la source est reliée, de préférence connectée, à la source du potentiel de référence bas GND, dont le drain est relié, de préférence connecté, au drain du transistor MOS TM12, et dont la grille est reliée, de préférence connectée, au drain du transistor MOS TM12 ;
- un transistor MOS TM14 par exemple à canal P, dont la source est reliée, de préférence connectée, à la source de la tension d'alimentation Vcc, et dont la grille reçoit la tension pbias ;
- un transistor MOS TM15, par exemple à canal N, dont la source est reliée, de préférence connectée, à la source du potentiel de référence bas GND, dont le drain est relié, de préférence connecté, au drain du transistor MOS TM14, et dont la grille est reliée, de préférence connectée, au drain du transistor MOS TM12 ; et
- un inverseur INV1 dont l'entrée est reliée, de préférence connectée, au drain du transistor TM15.

Le signal fourni par l'inverseur INV1 correspond au premier signal de test élémentaire TEST1.

La figure 6 est un schéma électrique d'un mode de réalisation du deuxième circuit de test élémentaire 90.

Le circuit de test élémentaire 90 comprend :
- un transistor MOS TM16 par exemple à canal P, dont la source est reliée, de préférence connectée, à la source de la tension d'alimentation Vcc, et dont la grille est reliée, de préférence connectée, à la grille du transistor MOS TM2 ;
- un transistor MOS TM17, par exemple à canal N, dont la source est reliée, de préférence connectée, à la source du potentiel de référence bas GND, dont le drain est relié, de préférence connecté, au drain du transistor TM16, et dont la grille reçoit la tension Vc_TB4 du collecteur du transistor bipolaire TB4 ; et
- un inverseur INV2 dont l'entrée est reliée, de préférence connectée, au drain du transistor TM17.

Le signal fourni par l'inverseur INV2 correspond au deuxième signal de test élémentaire TEST2. Le circuit de test de démarrage 75 a une structure simple et comprend un nombre réduit de composants électroniques. La surface occupée par le circuit de test de démarrage 75 est réduite par rapport à la surface occupée par le circuit de référence de tension 20 lorsque ces circuits sont réalisés de façon intégrée.

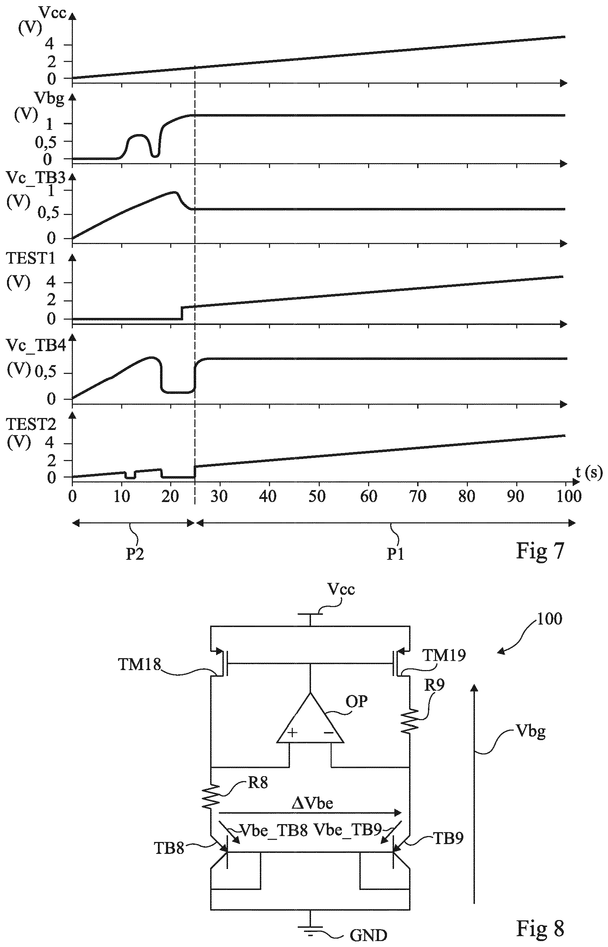

La figure 7 représente des chronogrammes de tensions lors du fonctionnement du circuit 70 comprenant le circuit de référence de tension 20 équipé du circuit de test de démarrage 75. En particulier, la figure 7 représente des chronogrammes de la tension d'alimentation Vcc, de la référence de tension Vbg, de la tension Vc_TB3 au collecteur du transistor bipolaire TB3, du premier signal de test TEST1, de la tension Vc_TB4 au collecteur du transistor bipolaire TB4, et du deuxième signal de test TEST2.

L'évolution de la tension Vcc étant très lente, les chronogrammes de la figure 7 sont en fait représentatifs d'un fonctionnement en statique du circuit 75 pour différentes valeurs de la tension d'alimentation Vcc. Le premier signal de test élémentaire TEST1 est à l'état logique "1" lorsqu'il est sensiblement égal à la tension d'alimentation Vcc et est à l'état logique "0" lorsqu'il est sensiblement égal à 0 V. Le deuxième signal de test élémentaire TEST2 est à l'état logique "1" lorsqu'il est sensiblement égal à la tension d'alimentation Vcc et est à l'état logique "0" lorsqu'il est sensiblement égal à 0 V.

En fonctionnement normal, la référence de tension Vgb fournie par le circuit de référence de tension 20 est égale à la valeur souhaitée, qui est dans le présent exemple égale à 1,2 V. Dans la plage P1, c'est-à-dire pour une tension d'alimentation Vcc supérieure à environ 1,4 V, la tension Vbg a la valeur souhaitée. Dans la plage P1, le premier signal de test élémentaire TEST1 est à l'état logique "1" et le deuxième signal de test élémentaire TEST2 est à l'état logique "1". Dans la plage P2, c'est-à-dire pour une tension d'alimentation Vcc inférieure à 1,4 V, la tension Vbg est inférieure à la valeur souhaitée. Dans la plage P2, au moins l'un du premier signal de test TEST1 et du deuxième signal de test TEST2 est à l'état logique "0". On notera en particulier que, dans la plage P2, le premier signal de test élémentaire TEST1 est à l'état logique "0" lorsque la tension d'alimentation Vcc est inférieure à environ 1 V et est à l'état logique "1" lorsque la tension d'alimentation Vcc est supérieure à environ 1 V, et que le deuxième signal de test élémentaire TEST2 est à l'état logique "0" sur deux sous-plages distinctes de la tension d'alimentation Vcc, dont l'une se termine à 1,5 V.

La figure 8 est un schéma électrique d'un autre exemple d'un circuit de référence de tension 100.

Le circuit 100 comprend :
- un transistor bipolaire TB8, par exemple de type PNP, dont l'émetteur est relié, de préférence connecté, à une première borne d'une résistance R8, dont le collecteur est relié, de préférence connecté, à la source du potentiel de référence bas GND, et dont la base est reliée, de préférence connectée au collecteur ;
- un transistor bipolaire TB9, par exemple de type PNP, dont l'émetteur est relié, de préférence connecté, à une première borne d'une résistance R9, dont le collecteur est relié, de préférence connecté, à la source du potentiel de référence bas GND, et dont la base est reliée, de préférence connectée au collecteur et à la base du transistor bipolaire TB8 ;
- un transistor MOS TM18, par exemple à canal P, dont la source est reliée, de préférence connectée, à la source de la tension d'alimentation Vcc, et dont le drain est relié, de préférence connecté, à une deuxième borne de la résistance R8 ;
- un transistor MOS TM19, par exemple à canal P, dont la source est reliée, de préférence connectée, à la source de la tension d'alimentation Vcc, dont le drain est relié, de préférence connecté, à une deuxième borne de la résistance R9, et dont la grille est reliée à la grille du transistor MOS TM18 ; et
- un amplificateur opérationnel OP dont l'entrée non inverseuse (+) est reliée, de préférence connectée, à la deuxième borne de la résistance R8, dont l'entrée inverseuse (-) est reliée, de préférence connectée, à la première borne de la résistance R9, et dont la sortie est reliée, de préférence connectée, aux grilles des transistors MOS TM18 et TM19.

Le circuit de référence de tension 100 fournit une référence de tension Vbg à la deuxième borne de la résistance R9. Le principe de fonctionnement du circuit de référence de tension 100 est le suivant : la tension aux bornes de la résistance R9 augmente avec la température tandis que la tension collecteur-émetteur du transistor bipolaire TB9 diminue avec la température, de sorte que la référence de tension Vbg reste constante avec la température en choisissant les résistances R8 et R9 de façon adaptée. De façon plus détaillée, le transistor bipolaire TB8 présente un facteur d'amplification supérieur à 1 par rapport au transistor bipolaire TB9, de sorte que la tension base-émetteur Vbe_TB8 du transistor bipolaire TB8 est inférieure à la tension base-émetteur Vbe_TB9 du transistor bipolaire TB9. La différence ΔVbe entre les tensions Vbe_TB8 et Vbe_TB9 est proportionnelle à la température absolue. L'amplificateur opérationnel OP impose que les tensions à ses entrées inverseuse et non inverseuse soient égales, de sorte que le courant traversant la résistance R8 est égal à ΔVbe/R8. Le miroir de courant formé par les transistors MOS TM18 et TM19 impose que le courant traversant la résistance R9 soit également égal à ΔVbe/R8. La tension Vbg est alors égale à la somme de la tension aux bornes de la résistance R9, égale à R9*ΔVbe/R8 et de la tension émetteur-base du transistor bipolaire TB9. De nombreuses variantes du circuit de la figure 8 sont possibles.

La mise en oeuvre du procédé de conception décrit précédemment en relation avec la figure 3 au circuit de référence de tension 100 de la figure 8 conduit à déterminer qu'au moins un empilement critique fait partie de l'amplificateur opérationnel.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Circuit électronique (70) comprenant un circuit (20) de référence de tension et un circuit (75) de test de démarrage du circuit de référence de tension, le circuit (20) de référence de tension comprenant au moins un premier empilement d'un premier transistor (TM5), comprenant une première borne de commande recevant un premier signal de commande (pbias), et d'un deuxième transistor (TM6), comprenant une deuxième borne de commande recevant un deuxième signal de commande (Vc_TB3), et le circuit de test de démarrage comprenant au moins un premier circuit (80) de test élémentaire comprenant un deuxième empilement d'un troisième transistor (TM11) et d'un quatrième transistor (TM12), le troisième transistor étant du même type que le premier transistor et comprenant une troisième borne de commande recevant le premier signal de commande, le quatrième transistor étant du même type que le deuxième transistor et comprenant une quatrième borne de commande recevant le deuxième signal de commande, le premier circuit de test élémentaire étant configuré pour fournir un premier signal binaire (TEST1).

2. Circuit électronique selon la revendication 1, dans lequel le circuit (20) de référence de tension est destiné à être connecté à une source d'une tension d'alimentation (Vcc) et à une source d'un potentiel de référence (GND), dans lequel le premier transistor (TM5) et le deuxième transistor (TM6) sont reliés en série entre la source de la tension d'alimentation et la source du potentiel de référence, et dans lequel le troisième transistor (TM11) et le quatrième transistor (TM12) sont reliés en série entre la source de la tension d'alimentation et la source du potentiel de référence.

3. Circuit électronique selon la revendication 1 ou 2, dans lequel les premier, deuxième, troisième et quatrième transistors (TM5, TM6, TM11, TM12) sont des transistors MOS.

4. Circuit électronique selon l'une quelconque des revendications 1 à 3, dans lequel le premier transistor (TM5) et le deuxième transistor (TM6) sont du même type, et dans lequel le premier circuit (80) de test élémentaire comprend, en outre, un cinquième transistor (TM14) en série avec un sixième transistor (TM15), le cinquième transistor comprenant une cinquième borne de commande recevant le premier signal de commande (pbias) et le sixième transistor comprenant une sixième borne de commande recevant un signal à un noeud intermédiaire du deuxième empilement, le premier signal binaire (TEST1) correspondant à la tension au noeud milieu entre le cinquième transistor et le sixième transistor.

5. Circuit électronique selon l'une quelconque des revendications 1 à 4, dans lequel le circuit (20) de référence de tension comprend au moins un troisième empilement d'un septième transistor (TM8), comprenant une septième borne de commande recevant un troisième signal de commande (pbias), et d'un huitième transistor (TM9), comprenant une huitième borne de commande recevant un quatrième signal de commande (Vc_TB4), et dans lequel le circuit (75) de test de démarrage comprend au moins un deuxième circuit (90) de test élémentaire comprenant un quatrième empilement d'un neuvième transistor (TM16) et d'un dixième transistor (TM17), le neuvième transistor étant du même type que le septième transistor et comprenant une neuvième borne de commande recevant le troisième signal de commande, le dixième transistor étant du même type que le huitième transistor et comprenant une dixième borne de commande recevant le quatrième signal de commande, le deuxième circuit de test élémentaire étant configuré pour fournir un deuxième signal binaire (TEST2).

6. Circuit électronique selon la revendication 5, dans lequel le troisième signal de commande (pbias) est identique au premier signal de commande.

7. Circuit électronique selon la revendication 5 ou 6 et la revendication 2, dans lequel le septième transistor (TM8) et le huitième transistor (TM9) sont reliés en série entre la source de la tension d'alimentation (Vcc) et la source du potentiel de référence (GND), et dans lequel le neuvième transistor (TM16) et le dixième transistor (TM17) sont reliés en série entre la source de la tension d'alimentation et la source du potentiel de référence.

8. Circuit électronique selon l'une quelconque des revendications 5 à 7, dans lequel le septième transistor (TM8) et le huitième transistor (TM9) sont de types différents, et dans lequel le deuxième signal binaire (TEST2) correspond à la tension au noeud milieu entre le neuvième transistor (TM16) et le dixième transistor (TM17).

9. Circuit électronique selon l'une quelconque des revendications 5 à 8, dans lequel les septième, huitième, neuvième et dixième transistors (TM8, TM9, TM16, TM17) sont des transistors MOS.

10. Circuit électronique selon l'une quelconque des revendications 5 à 9, comprenant un circuit PTAT (30), un premier étage d'amplification (40), et un deuxième étage d'amplification (50), le premier étage d'amplification (40) comprenant un onzième transistor (TB3) et un douzième transistor (TB4), le deuxième signal de commande (Vc_TB3) étant la tension à une borne de puissance du onzième transistor, et le quatrième signal de commande (Vc_TB4) étant la tension à une borne de puissance du douzième transistor.

## Patentansprüche

1. Elektronische Schaltung (70) aufweisend eine Spannungsreferenzschaltung (20) und eine Schaltung (75) zum Überprüfen des Starts der Spannungsreferenzschaltung, wobei die Spannungsreferenzschaltung (20) wenigstens einen ersten Stapel eines ersten Transistors (TM5) aufweist, der einen ersten Steueranschluss aufweist, der ein erstes Steuersignal (pbias) empfängt, und eines zweiten Transistors (TM6), der einen zweiten Steueranschluss aufweist, der ein zweites Steuersignal (Vc_TB3) empfängt, und wobei die Startprüfungsschaltung wenigstens eine erste Elementartestschaltung (80) aufweist, die einen zweiten Stapel aus einem dritten Transistor (TM11) und einem vierten Transistor (TM12) aufweist, wobei der dritte Transistor vom gleichen Typ wie der erste Transistor ist und einen dritten Steueranschluss aufweist, der das erste Steuersignal empfängt, wobei der vierte Transistor vom gleichen Typ wie der zweite Transistor ist und einen vierten Steueranschluss aufweist, der das zweite Steuersignal empfängt, wobei die erste Elementartestschaltung konfiguriert ist zum Liefern eines ersten Binärsignals (TEST1).

2. Elektronische Schaltung nach Anspruch 1, wobei die Spannungsreferenzschaltung (20) dazu bestimmt ist, mit einer Quelle einer Versorgungsspannung (Vcc) und mit einer Quelle eines Referenzpotentials (GND) verbunden zu werden, wobei der erste Transistor (TM5) und der zweite Transistor (TM6) zwischen der Quelle der Versorgungsspannung und der Quelle des Referenzpotentials in Reihe geschaltet sind und wobei der dritte Transistor (TM11) und der vierte Transistor (TM12) in Reihe zwischen der Quelle der Versorgungsspannung und der Quelle des Referenzpotentials geschaltet sind.

3. Elektronische Schaltung nach Anspruch 1 oder 2, wobei der erste, zweite, dritte und vierte Transistor (TM5, TM6, TM11, TM12) MOS-Transistoren sind.

4. Elektronische Schaltung nach einem der Ansprüche 1 bis 3, wobei der erste Transistor (TM5) und der zweite Transistor (TM6) vom gleichen Typ sind und wobei die erste Elementartestschaltung (80) ferner einen fünften Transistor (TM14) in Reihe mit einem sechsten Transistor (TM15) aufweist, wobei der fünfte Transistor einen fünften Steueranschluss aufweist, der das erste Steuersignal (pbias) empfängt, und der sechste Transistor einen sechsten Steueranschluss aufweist, der ein Signal an einem Zwischenknoten des zweiten Stapels empfängt, wobei das erste Binärsignal (TEST1) der Spannung am Verbindungsknoten zwischen dem fünften Transistor und dem sechsten Transistor entspricht.

5. Elektronische Schaltung nach einem der Ansprüche 1 bis 4, wobei die Spannungsreferenzschaltung (20) wenigstens einen dritten Stapel aufweist aus einem siebten Transistor (TM8), der einen siebten Steueranschluss aufweist, der ein drittes Steuersignal (pbias) empfängt, und einem achten Transistor (TM9),der einen achten Steueranschluss aufweist, der ein viertes Steuersignal (Vc_TB4) empfängt, wobei die Startprüfungsschaltung (75) wenigstens eine zweite Elementartestschaltung (90) aufweist, die einen vierten Stapel aus einem neunten Transistor (TM16) und einem zehnten Transistor (TM17) aufweist, wobei der neunte Transistor vom gleichen Typ wie der siebte Transistor ist und einen neunten Steueranschluss aufweist, der das dritte Steuersignal empfängt, wobei der zehnte Transistor vom gleichen Typ wie der achte Transistor ist und einen zehnten Steueranschluss aufweist, der das vierte Steuersignal empfängt, wobei die zweite Elementartestschaltung konfiguriert ist zum Liefern eines zweiten Binärsignals (TEST2).

6. Elektronische Schaltung nach Anspruch 5, wobei das dritte Steuersignal (pbias) mit dem ersten Steuersignal identisch ist.

7. Elektronische Schaltung nach Anspruch 5 oder 6 und Anspruch 2, wobei der siebte Transistor (TM8) und der achte Transistor (TM9) zwischen der Quelle der Versorgungsspannung (Vcc) und der Quelle des Referenzpotentials (GND) in Reihe geschaltet sind und wobei der neunte Transistor (TM16) und der zehnte Transistor (TM17) zwischen der Quelle der Versorgungsspannung und der Quelle des Referenzpotentials in Reihe geschaltet sind.

8. Elektronische Schaltung nach einem der Ansprüche 5 bis 7, wobei der siebte Transistor (TM8) und der achte Transistor (TM9) von unterschiedlichem Typ sind und wobei das zweite Binärsignal (TEST2) der Spannung am Verbindungsknoten zwischen dem neunten Transistor (TM16) und dem zehnten Transistor (TM17) entspricht.

9. Elektronische Schaltung nach einem der Ansprüche 5 bis 8, wobei der siebte, achte, neunte und zehnte Transistor (TM8, TM9, TM16, TM17) MOS-Transistoren sind.

10. Elektronische Schaltung nach einem der Ansprüche 5 bis 9, aufweisend eine PTAT-Schaltung (40), eine erste Verstärkerstufe (50) und eine zweite Verstärkerstufe (60), wobei die erste Verstärkerstufe (50) einen elften Transistor (TB3) und einen zwölften Transistor (TB4) aufweist, wobei das zweite Steuersignal (Vc_TB3) die Spannung an einem Leistungsanschluss des elften Transistors ist und das vierte Steuersignal (Vc_TB4) die Spannung an einem Leistungsanschluss des zwölften Transistors ist.

## Claims

1. Electronic circuit (70) comprising a voltage reference circuit (20) and a circuit (75) for checking the starting of the voltage reference circuit, the voltage reference circuit (20) comprising at least one first stack of a first transistor (TM5), comprising a first control terminal receiving a first control signal (pbias), and of a second transistor (TM6), comprising a second control terminal receiving a second control signal (Vc_TB3), and the start check circuit comprising at least one first elementary test circuit (80) comprising a second stack of a third transistor (TM11) and of a fourth transistor (TM12), the third transistor being of the same type as the first transistor and comprising a third control terminal receiving the first control signal, the fourth transistor being of the same type as the second transistor and comprising a fourth control terminal receiving the second control signal, the first elementary test circuit being configured to deliver a first binary signal (TEST1).

2. Electronic circuit according to claim 1, wherein the voltage reference circuit (20) is intended to be connected to a source of a power supply voltage (Vcc) and to a source of a reference potential (GND), wherein the first transistor (TM5) and the second transistor (TM6) are series-coupled between the source of the power supply voltage and the source of the reference potential, and wherein the third transistor (TM11) and the fourth transistor (TM12) are series-coupled between the source of the power supply voltage and the source of the reference potential.

3. Electronic circuit according to claim 1 or 2, wherein the first, second, third, and fourth transistors (TM5, TM6, TM11, TM12) are MOS transistors.

4. Electronic circuit according to any of claims 1 to 3, wherein the first transistor (TM5) and the second transistor (TM6) are of the same type, and wherein the first elementary test circuit (80) further comprises a fifth transistor (TM14) in series with a sixth transistor (TM15), the fifth transistor comprising a fifth control terminal receiving the first control signal (pbias) and the sixth transistor comprising a sixth control terminal receiving a signal at an intermediate node of the second stack, the first binary signal (TEST1) corresponding to the voltage at the junction node between the fifth transistor and the sixth transistor.

5. Electronic circuit according to any of claims 1 to 4, wherein the voltage reference circuit (20) comprises at least one third stack of a seventh transistor (TM8), comprising a seventh control terminal receiving a third control signal (pbias), and of an eighth transistor (TM9) comprising an eighth control terminal receiving a fourth control signal (Vc_TB4), and wherein the start check circuit (75) comprises at least one second elementary test circuit (90) comprising a fourth stack of a ninth transistor (TM16) and of a tenth transistor (TM17), the ninth transistor being of the same type as the seventh transistor and comprising a ninth control terminal receiving the third control signal, the tenth transistor being of the same type as the eighth transistor and comprising a tenth control terminal receiving the fourth control signal, the second elementary test circuit being configured to deliver a second binary signal (TEST2).

6. Electronic circuit according to claim 5, wherein the third control signal (pbias) is identical to the first control signal.

7. Electronic circuit according to claim 5 or 6 and claim 2, wherein the seventh transistor (TM8) and the eighth transistor (TM9) are series-coupled between the source of the power supply voltage (Vcc) and the source of the reference potential (GND), and wherein the ninth transistor (TM16) and the tenth transistor (TM17) are series-coupled between the source of the power supply voltage and source of the reference potential.

8. Electronic circuit according to any of claims 5 to 7, wherein the seventh transistor (TM8) and the eighth transistor (TM9) are of different types, and wherein the second binary signal (TEST2) corresponds to the voltage at the junction node between the ninth transistor (TM16) and the tenth transistor (TM17).

9. Electronic circuit according to any of claims 5 to 8, wherein the seventh, eighth, ninth, and tenth transistors (TM8, TM9, TM16, TM17) are MOS transistors.

10. Electronic circuit according to any of claims 5 to 9, comprising a PTAT circuit (40), a first amplification stage (50), and a second amplification stage (60), the first amplification stage (50) comprising an eleventh transistor (TB3) and a twelfth transistor (TB4), the second control signal (Vc_TB3) being the voltage at a power terminal of the eleventh transistor, and the fourth control signal (Vc_TB4) being the voltage at a power terminal of the twelfth transistor.
